(19) Europäisches Patentamt / European Patent Office / Office européen des brevets

(11) **EP 2 797 225 B1**

(12) **EUROPEAN PATENT SPECIFICATION**

(45) Date of publication and mention
of the grant of the patent:
**10.01.2018 Bulletin 2018/02**

(51) Int Cl.:
***H03D 1/22*** *(2006.01)*

(21) Application number: **13165246.3**

(22) Date of filing: **24.04.2013**

(54) **Method of and apparatus for demodulating an amplitude modulated signal**

Verfahren und Vorrichtung zur Demodulation eines amplitudenmodulierten Signals

Procédé et appareil permettant de démoduler un signal modulé en amplitude

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**29.10.2014 Bulletin 2014/44**

(73) Proprietor: **Analog Devices Global
Hamilton (BM)**

(72) Inventor: **Venkitasubramani Anand
Trivandrum (IN)**

(74) Representative: **Mears, Andrew David et al
Withers & Rogers LLP
4 More London Riverside
London SE1 2AU (GB)**

(56) References cited:
**WO-A1-86/05936     US-A1- 2008 079 485
US-B2- 7 920 653**

• FRIGON J ET AL: "Field trial results for high-speed wireless indoor data communications", IEEE JOURNAL ON SELECTED AREAS IN COMMUNICATIONS, IEEE SERVICE CENTER, PISCATAWAY, US, vol. 18, no. 3, 1 March 2000 (2000-03-01), pages 297-309, XP011449969, ISSN: 0733-8716, DOI: 10.1109/49.840190
• VEERENDRA BHARGAV ALLURI ET AL: "A New Multichannel, Coherent Amplitude Modulated, Time-Division Multiplexed, Software-Defined Radio Receiver Architecture, and Field-Programmable-Gate-Array Technology Implementation", IEEE TRANSACTIONS ON SIGNAL PROCESSING, IEEE SERVICE CENTER, NEW YORK, NY, US, vol. 58, no. 10, 1 October 2010 (2010-10-01), pages 5369-5384, XP011312659, ISSN: 1053-587X

## Description

## FIELD

This disclosure relates to a method of and apparatus for demodulating an amplitude modulated signal.

## BACKGROUND

Synchronous methods for AM demodulation require the phase of the local oscillator to be synchronized with the phase of the carrier of a received AM signal. The consequence of a mismatch in these phases is that a demodulated signal comprises the baseband message signal multiplied by the cosine of the introduced phase offset. Accordingly, known demodulation circuits typically include complex hardware such as a phase locked loop (PLL) to lock the local oscillator in frequency and phase with the signal to be demodulated. This hardware is inefficient and takes up valuable space on-chip.

Veerendra Bhargav Alluri, J. et al ("A New Multichannel, Coherent AM, TDM, SDR Receiver Architecture, and FPGA Technology Implementation," IEEE Sig. Proc., vol. 58, no. 10, pp. 5369-5384, Oct 2010) describes a software implemented AM radio receiver implemented using PLD FPGA technology, specifically LUTs, D-FFs and small multiplexers. Frigon J. et al. ("Field trial results for high-speed wireless indoor data communications", IEEE Journal on selected areas in communications, vol. 18, no. 3, pp 297-309, 1 March 2000) describes another quadrature demodulator using digital processing.

## SUMMARY

According to a first aspect there is provided a method of demodulating an amplitude modulated (AM) signal, the method comprising: receiving the AM signal in an analogue domain; generating a digital representation of the AM signal; and in the digital domain: multiplying the digital representation with two or more digitally synthesised local oscillator signals to produce a first signal (*I*) and a second signal (*Q*) substantially 90 degrees out of phase with the first signal; and processing the first signal and the second signal to demodulate the received AM signal to generate a demodulated digital signal, characterised in that the step of processing comprises calculating the phase offset ($\Phi$) between the local oscillator signals and a carrier wave of the received AM signal, low-pass filtering the first signal (I) to generate a resultant digital signal (b cos $\Phi$); and multiplying the resultant digital signal (b cos $\Phi$) with the inverse cosine of the calculated phase offset (cos$^{-1}$ $\Phi$).

By processing the received AM signal in the digital domain, the effects associated with gain and phase imbalance inherent in analogue mixers are completely eradicated. Accordingly, in embodiments of the present invention, any error introduced into the first and second signals due to phase offset between the AM carrier and the digitally synthesised local oscillator signal(s) may be completely or substantially cancelled during subsequent processing. As a result, signal-to-noise ratio (SNR) is not substantially degraded by digital quadrature mixing.

In other embodiments, the processing step may include square rooting the sum of the square of the first signal and the square of the second signal to produce a demodulated digital signal. Thus, the introduced error due to phase offset introduced during the multiplying step may be cancelled leaving a scaled message signal having a DC offset plus a high frequency component which may be removed at a later stage, for example by a digital filter.

Alternatively the processing step may include converting the first signal and the second signal into a first baseband signal and a second baseband signal, and in other embodiments square rooting the sum of the square of the first baseband signal and the square of the second baseband signal to produce a demodulated digital signal. Thus the resultant output is a demodulated digital baseband signal, the radio frequency (RF) component of the received AM signal having been removed. Additionally, any frequency offset present between the local oscillator signal(s) and the AM carrier is cancelled. Any frequency offset may, however, shift the baseband signal by the value of the frequency offset. Accordingly, digitally implemented low pass filters preferably each have a high enough cut-off so as to pass the first and second respective baseband signals, shifted by the value of the frequency offset.

Conversion of the first and second signals into the first and second baseband signals may be performed using one or more digitally implemented low-pass filters, such as finite impulse response filters.

Optionally, the DC component of the demodulated digital signal may be removed, preferably by digital estimation and subtraction or the use of known digitally implemented high-pass filtering techniques.

An analogue representation of the demodulated digital signal may then be generated. Any known digital-to-analogue converter (DAC) may be used to generate the analogue representation.

The phase offset between one or more of the local signals and the carrier of the AM signal is also calculated. The phase offset ($\Phi$) may be determined by cal-

culating $\Phi = \tan^{-1}\left(\dfrac{I}{Q}\right).$

Any frequency offset present between the local oscillator signals and the AM carrier may be calculated from the calculated phase offset ($\Phi$). The frequency offset may be determined by calculating the derivative of the phase difference with respect to time.

The calculated frequency offset may be used to adjust the frequency of the local oscillator signals until the frequency offset is substantially zero.

In some embodiments of the invention, provided the frequency offset is zero, the calculated phase offset may also then be used to adjust the multiplying to achieve and preferably maintain a zero phase offset between one of the local signals and the AM carrier signal.

The calculated phase offset may be used to cancel the error introduced to the first and second signals at the multiplying step. Any introduced phase offset at this stage will be reflected by the demodulated signal being weighted by the cosine of the phase offset. The demodulated digital signal is multiplied by the inverse cosine of the calculated phase offset (cos$^{-1}$($\Phi$)), thus removing any error associated with an introduced phase offset at the multiplying stage.

According to a second aspect there is provided an apparatus for demodulating an amplitude modulated (AM) signal, comprising: an analogue to digital converter (ADC) for generating a digital representation of a received AM signal; and digital processing circuitry for: multiplying the digital representation with two or more digital representations of local oscillator signals to produce a first signal ($I$) and a second signal ($Q$) substantially 90 degrees out of phase with the first signal; and processing the first signal and the second signal to demodulate the received AM signal to generate a demodulated digital signal, characterised in that the step of processing comprises calculating the phase offset ($\Phi$) between the local oscillator signals and a carrier wave of the received AM signal, low-pass filtering the first signal (I) to generate a resultant digital signal (b cos $\Phi$); and multiplying the resultant digital signal (b cos $\Phi$) with the inverse cosine of the calculated phase offset (cos$^{-1}\Phi$).

## BRIEF DESCRIPTION OF THE DRAWINGS

Embodiments will now be described, by way of non-limiting example only, with reference to the accompanying drawings, in which:

Figure 1 is a block diagram of an apparatus for demodulating an AM signal;

Figure 2 is a schematic diagram showing functions implemented within the apparatus shown in Figure 1;

Figure 3 is a schematic diagram of a variation of the apparatus for demodulating an AM signal shown in Figures 1 and 2; and

Figure 4 is a schematic diagram of a variation of the apparatus for demodulating an AM signal shown in Figures 1 and 2.

## DESCRIPTION OF EMBODIMENTS

Amplitude modulation (AM) is a technique commonly used in the transmission of information, typically audio signals, on a radio frequency (RF) carrier wave. Demodulation of an amplitude modulated (AM) signal traditionally involves synchronizing a local oscillator with the RF carrier using complex hardware such as a phase locked loop (PLL) to lock the local oscillator in phase and frequency with the received AM carrier. Such circuitry is inefficient and bulky, taking up valuable space on chip. Alternative analogue regimes have also been proposed. However, imperfections in analogue circuitry often lead to phase and frequency errors and, as a consequence, phase and frequency offsets between the AM carrier and the local oscillator lead to degradation of the signal-to-noise ratio (SNR) of the demodulated signal. Embodiments described herein allow demodulation to be performed without the requirement for complex analog circuitry.

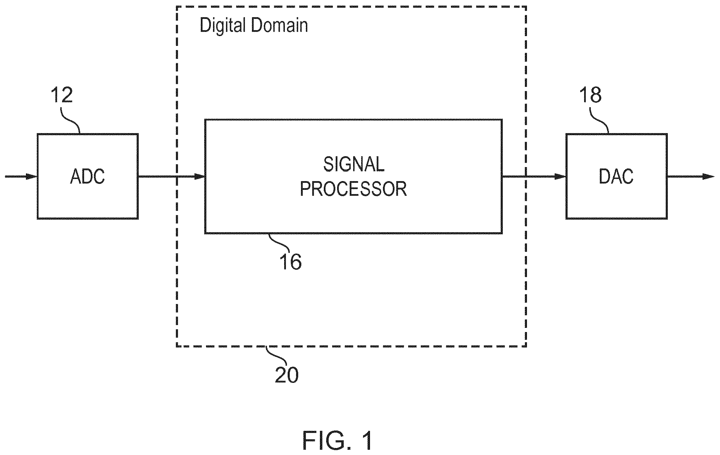

Figure 1 is a schematic illustration of an apparatus for demodulating an amplitude modulated (AM) signal. The apparatus comprises an analogue to digital converter (ADC) 12, a digital signal processing circuit 16 and a digital to analogue converter (DAC) 18 which is optionally provided to convert the digital output of the signal processing circuit 16 into an analogue signal. Broken line 20 denotes the digital domain in which the signal processing circuitry 16 operates. Generally, the apparatus is operable to receive an AM signal and demodulate the signal in the digital domain. In operation, an AM signal is received at the ADC 12. The AM signal may be at an intermediate frequency (IF) shifted from an original carrier frequency using known methods. Alternatively, in homodyne operation (direct conversion), the AM input signal at the ADC 12 may be directly received from a radio frequency (RF) receiver. The ADC 12 is operable to generate a digital representation of the AM input signal which may then be passed to the digital signal processing circuit 16. As will be described in more detail below, signal processing circuit 16 may process a digitally represented AM signal to detect an envelope of the received AM signal and thus extract a demodulated digital signal.

The demodulated digital signal may then be output to the optional DAC 18 where it may be converted to an analogue representation of the demodulated digital signal.

The signal processing circuit 16 may be implemented in dedicated hardware, such as an application specific integrated circuit (ASIC), or using suitable programmable processing hardware such as a digital signal processor (DSP) or field programmable gate array (FPGA), or a mixture of both application specific and non-specific hardware.

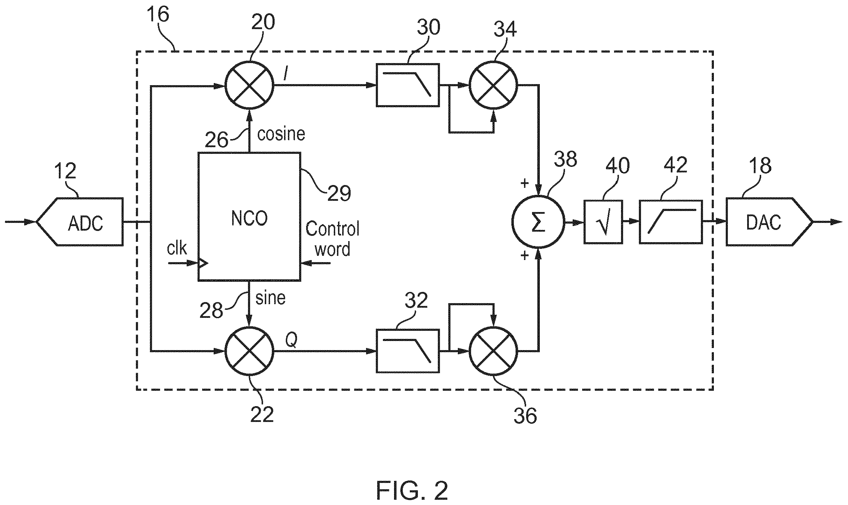

Referring now to Figure 2, a schematic diagram of the demodulation apparatus 10 of Figure 1 is shown with the functional blocks of an embodiment of the signal processing circuit 16 illustrated in more detail. The digital representation of the AM signal is first split into first and second identical digital representations or words, which are then multiplied at first and second multipliers 20, 22 by digital representations of cosine 26 and sine 28 waves respectively, having a frequency notionally identical to that of the carrier of the AM signal at the input of the ADC 12. These cosine 24 and sine 26 representations are generated by a numerically controlled oscillator (NCO) 29 or other local oscillator adapted to output a two strings of digital words which represent cosine and sine signals. Accordingly, multipliers 20, 22 and NCO 29 make up a digital equivalent of a quadrature mixer. Whilst embodiments are described here using sinusoidal signals 26, 28, it will be appreciated that other digital waveform approximations such as triangle, square wave and sawtooth wave approximations could equally be used. In which case calculations described herein in relation to cosine and sine signals 26, 28 may be replaced with equivalent calculations of other waveform approximations. As noted previously, the NCO 29 generates two digital signals 26, 28 having a frequency substantially identical to that of the carrier frequency ($\omega_c$) of the received AM signal and a respective phase difference of $\pi/2$ radians (90 degrees) between one another. Thus, multiplication at the first and second multipliers 20, 22 generates two digital component signals - an in-phase component signal ($I$) and a quadrature component signal $\pi/2$ radians out of phase with the first component signal 26. In-phase and quadrature component digital words may be represented as follows.

A received AM signal may be defined as:

$$\text{Received AM signal} = \text{b} \cos \left( \omega_c t \right)$$

where b = 1 + k.m(t); k - modulation index, m(t) - modulated message.

Thus, the mixed in-phase component signal may be represented as:

$$I = \text{b} \cos \left( \omega_c t \right) \cos \left( \omega_c t + \Phi \right)$$

which, using trigonometric identities, equates to:

$$I = \frac{1}{2} \text{b} \left( \cos \left( \Phi \right) + \cos \left( 2\omega_c t + \Phi \right) \right)$$

where $\Phi$ represents the phase offset between the local oscillator 29 and the AM carrier frequency $\omega_c$.

Similarly, the quadrature component signal may be represented as follows:

$$Q = \text{b} \cos \left( \omega_c t \right) \sin \left( \omega_c t + \Phi \right)$$

again, using trigonometric identities:

$$Q = \frac{1}{2} \text{b} \left( \sin \left( 2\omega_c t + \Phi \right) - \sin \left( - \Phi \right) \right)$$

$$Q = \frac{1}{2} \text{b} \left( \sin \Phi + \sin \left( 2\omega_c t + \Phi \right) \right)$$

The mixed in-phase and quadrature component signals may then be passed to the first and second digitally implemented low pass filters 30, 32 where the high frequency component, $2\omega_c$, of the in-phase and quadrature signals $I$ and $Q$ may be removed. Low pass filters 30, 32 may be implemented as a finite impulse response (FIR) filter or using any other known digital filter implementation. The resultant output is defined below:

$$I = \text{b} \cos \Phi$$

$$Q = \text{b} \sin \Phi$$

Using the trigonometric identity $\cos^2\theta + \sin^2\theta = 1$, the value of $b$ can be determined by the signal processing circuit 16, where b represents the demodulated message inclusive of DC bias and some scaling which depends on the demodulation index $k$. Accordingly the two baseband component words output from the digital low pass filters 30, 32 may be squared at multipliers 34, 36 and the squared output summed at summer 38. A square root 40 function may then be applied to the summed output. The equivalent function performed by digital signal processing circuit 16, by squaring, summing and square rooting the filtered in-phase and quadrature words $I$ and $Q$ is shown below:

$$I + Q = \sqrt{\text{b}^2 \cos^2 \Phi + \text{b}^2 \sin^2 \Phi}$$

$$= \sqrt{\text{b}^2 \left( \cos^2 \Phi + \sin^2 \Phi \right)}$$

$$= \text{b} = 1 + \text{k.m(t)}$$

The output $b$ may then be passed to a digitally implemented high pass filter 42, such as a FIR filter, to remove the DC component of the demodulated digital word. The resultant signal with DC offset removed is a scaled version of the original message $m(t)$, scaled by the modulation index $k$.

Optionally this demodulated signal may then be provided to the DAC 18 to be subsequently converted to a demodulated analogue signal, such as an audio signal.

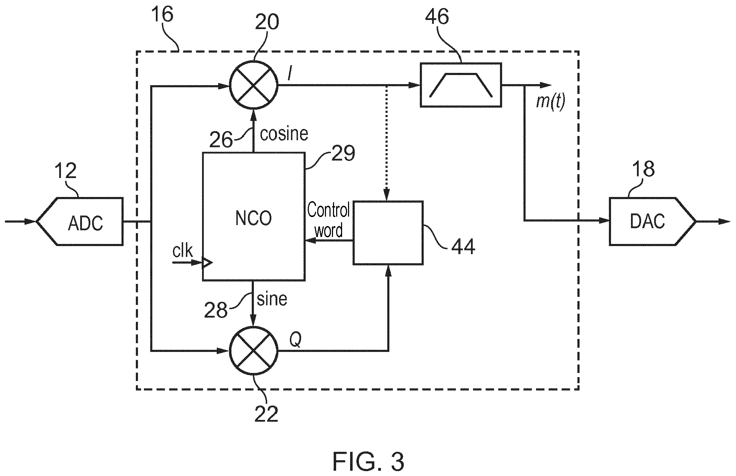

The phase offset $\Phi$ of the local oscillator 29 relative to the AM carrier may be determined from the value of $Q$. Since sin(0) = 0, when the phase offset $\Phi$ is zero, $Q$ is also zero. Accordingly, by monitoring $Q$ the phase of the local oscillator 29 relative to the AM carrier can be controlled such that $Q$ is maintained at zero. A further embodiment is shown in Figure 3, in which this method is implemented. An error correction module 44 receives the quadrature signal component, from which a measure of the difference in phase between the NCO 29 and the AM carrier may be determined. This measure may then be used to adjust the phase of the NCO 29 so as to zero the phase offset $\Phi$ with respect to the received AM carrier. This phase offset feedback loop 44 can therefore maintain the phase offset $\Phi$ at substantially zero. The effect of this is that, with the carrier component removed from the in-phase signal $I$, AM modulation of the in-phase carrier is cancelled by multiplication with the digital cosine 26 representation, as shown below.

$$ I = \frac{1}{2} b \left( \cos(\Phi) + \cos\left(2\omega_c t + \Phi\right) \right) $$

$$ I = \frac{1}{2} b \left( \cos(0) + \cos(0) \right); \Phi = 0 $$

$$ I = b = 1 + k.m(t) $$

Accordingly, the quadrature representation $Q$ is no longer required to demodulate the AM signal. $Q$ is only required for calculation of phase offset between the NCO 29 and the AM carrier. Optionally, the in-phase component may also be used to determine a direct value of the actual phase offset $\Phi$ using the following expression:

$$ \Phi = \tan^{-1}\left(\frac{I}{Q}\right) $$

where I is the in-phase component signal and $Q$ is the quadrature component signal, defined above. The calculated offset may then be used to control the control word of the NCO 29 to bring the NCO 29 into phase with the AM carrier and/or maintain the phase offset $\Phi$ at zero.

The in-phase component $I$ may be filtered by a digitally implemented bandpass filter 46 to remove the high frequency carrier component and the DC offset, the product of such filtering being a digital representation of the demodulated signal $m(t)$.

Time variant changes in the phase offset $\Phi$ may be indicative of a frequency mismatch between the carrier of the received AM signal at the ADC 12 and the local oscillator. By monitoring the phase offset over time, any frequency offset $f_{os}$ present between the carrier of the AM signal and the digital local oscillator signals may be determined and preferably cancelled. The frequency offset $f_{os}$ may be determined by calculating the first derivative of the phase offset, as set out below.

$$ f_{os} = \frac{d}{dt} \Phi $$

Where a frequency offset is identified, the calculated offset may then be used to control the control word of the NCO 29 to match the local oscillator frequency to that of the carrier of the incoming AM signal, i.e. such that $f_{os} = 0$. Once the frequency offset $f_{os}$ is removed, the phase offset $\Phi$, if present, will be constant. Accordingly, where a frequency offset is identified, the NCO 29 is preferably adjusted to remove the frequency offset before attending to removal of any phase offset $\Phi$ present between the NCO 29 and the AM carrier.

Monitoring of phase and frequency offset and corresponding adjustment of the local oscillator 29 may be performed simultaneously. Values of phase and frequency offset may be sampled at regular intervals throughout operation of the apparatus or alternatively only in certain circumstances. For example, phase and frequency offset may be reduced to zero during an initialisation phase. Phase and frequency values may the be regularly sampled to ensure that the phase and frequency of the NCO 29 is kept in synchronization with the AM carrier. Detected slipping of the NCO 29 out of synchronization may be used to adjust the local oscillator accordingly. The period between each sample may be dependent on the processing power and/or power constraints of a particular hardware implementation and/or the accuracy and quality of the demodulation required.

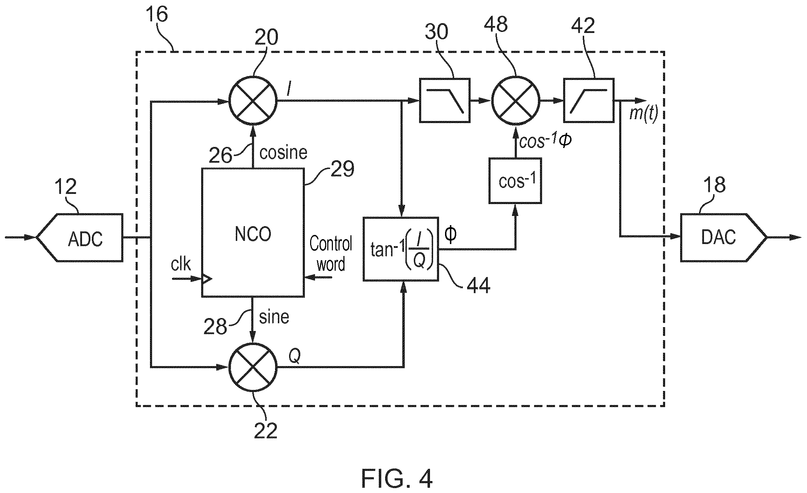

In a further embodiment, shown in Figure 4, the value of phase offset $\Phi$ determined from the in-phase and quadrature component words can be used to cancel the error introduced by phase offset $\Phi$ itself. The high frequency component is removed from the in-phase component signal $I$ by a digitally implemented low pass filter 30. The resultant digital signal ($I = b \cos \Phi$) is then multiplied at multiplier 48 by the inverse cosine of the phase offset $\Phi$. This cancels the error weighting (cos $\Phi$) due to phase offset leaving behind the demodulated digital signal $b$ which can then be filtered using a digitally implemented high pass filter 42 to remove any DC offset.

It will be appreciated that the functions described herein can be implemented in digital hardware, software or a combination thereof.

The disclosure has been made herein in terms of individual embodiments. However, those skilled in the art will appreciate that various embodiments, or features from one or more embodiments, may be combined as required. It will also be appreciated that various modifications may be made to these embodiments.

**Claims**

1. A method of demodulating an amplitude modulated (AM) signal, the method comprising:

receiving the AM signal in an analogue domain; generating a digital representation of the AM signal; and
in the digital domain:

multiplying the digital representation with two or more digitally generated local oscillator signals to produce a first signal (I) and a second signal (Q) substantially 90 degrees out of phase with the first signal; and processing the first signal and the second signal to demodulate the received AM signal to generate a demodulated digital signal, **characterised in that** the step of processing comprises:

calculating the phase offset (Φ) between the local oscillator signals and a carrier wave of the received AM signal; low-pass filtering the first signal (I) to generate a resultant digital signal, b cos Φ; and
multiplying the resultant digital signal, b cos Φ, with the inverse cosine of the calculated phase offset (cos⁻¹Φ).

2. A method as claimed in claim 1, wherein the processing step includes:

converting the first signal and the second signal into a first baseband signal and a second baseband signal.

3. A method as claimed in claims 1 or 2, further comprising substantially removing a DC component from the demodulated digital signal.

4. A method as claimed in any of claims 1 to 3, wherein one or more of the following apply:

a) the phase offset (Φ) is calculated by calculating $\Phi = \tan^{-1}\left( \frac{I}{Q} \right)$;

b) the calculated phase offset is used to adjust one or more of the local oscillator signals to maintain the phase difference between one of the local oscillator signals and the carrier of the received AM signal at substantially zero degrees.

5. A method according to any of claims 1 to 4, further comprising determining a frequency offset between one or more of the local oscillator signals and the carrier of the received AM signal.

6. A method according to claim 5, wherein the determined frequency offset is used to match the frequency of the one or more of the local oscillator signals with the frequency of the carrier of the received AM signal.

7. An apparatus for demodulating an amplitude modulated (AM) signal, comprising:

an analogue to digital converter (12) for generating a digital representation of a received AM signal; and
digital processing circuitry (16) for:

multiplying the digital representation with two or more digitally generated local oscillator signals to produce a first signal (I) and a second signal (Q) substantially 90 degrees out of phase with the first signal; and processing the first signal (I) and the second signal (Q) to demodulate the received AM signal to generate a demodulated digital signal, **characterised in that** the step of processing comprises:

calculating the phase offset (Φ) between the local oscillator signals and a carrier wave of the received AM signal; low-pass filtering the first signal (I) to generate a resultant digital signal, b cos Φ; and
multiplying the resultant digital signal, b cos Φ, with the inverse cosine of the calculated phase offset (cos⁻¹Φ).

8. An apparatus as claimed in claim 7, wherein the digital processing circuitry is further operable to:

convert the first signal and the second signal into a first baseband signal and a second baseband signal.

9. An apparatus as claimed in claim 8, wherein the digital processing circuitry comprises at least one low pass filter (30, 32) to convert the first and second signals into the first and second baseband signals.

10. An apparatus as claimed in any of claims 8 to 9, wherein the digital processing circuitry comprises a high pass filter (42) to remove a DC component from the demodulated digital signal.

11. An apparatus as claimed in any of claims 8 to 10, wherein the phase offset (Φ) is calculated by calculating $\Phi = \tan^{-1}\left( \frac{I}{Q} \right)$.

12. An apparatus as claimed in any of claims 8 to 11, wherein one or more of the following apply:

a) the digital processing circuitry (16) comprises a numerically controlled oscillator (29) and wherein a substantially realtime value of the phase offset is provided to the numerically controlled oscillator (29) to maintain the frequency of the numerically controlled oscillator (29) at the carrier frequency of the received AM signal.

**Patentansprüche**

1. Verfahren zum Demodulieren eines amplitudenmodulierten (AM) Signals, das Verfahren umfassend:

Empfangen eines AM-Signals in einer analogen Domäne;
Generieren einer digitalen Darstellung des AM-Signals; und
in der digitalen Domäne:

Multiplizieren der digitalen Darstellung mit zwei oder mehr digital generierten, örtlichen Oszillatorsignalen, um ein erstes Signal (I) und ein zweites Signal (Q), das im Wesentlichen 90 Grad zum ersten Signal phasenverschoben ist, zu produzieren; und
Verarbeiten des ersten Signals und des zweiten Signals, um das empfangene AM-Signal zu demodulieren, um ein demoduliertes digitales Signal zu generieren, **dadurch gekennzeichnet, dass** der Verarbeitungsschritt umfasst:

Berechnen der Phasenverschiebung (φ) zwischen den örtlichen Oszillatorsignalen und einer Trägerwelle des empfangenen AM-Signals;
Tiefpassfiltern des ersten Signals (I) zum Generieren eines resultierenden digitalen Signals, b cos φ; und
Multiplizieren des resultierenden Signals, b cos φ, mit dem Arkuskosinus der berechneten Phasenverschiebung $(\cos^{-1}\phi)$.

2. Verfahren nach Anspruch 1, wobei der Verarbeitungsschritt enthält:

Konvertieren des ersten Signals und des zweiten Signals in ein erstes Basisbandsignal und ein zweites Basisbandsignal.

3. Verfahren nach Anspruch 1 oder 2, ferner umfassend ein im Wesentlichen Entfernen einer Gleichstromkomponente aus dem digitalen Signal.

4. Verfahren nach einem der Ansprüche 1 bis 3, wobei eines oder mehrere der folgenden zutreffen:

a) die Phasenverschiebung (φ) wird durch Berechnen von $\phi = \tan^{-1}\left(\dfrac{I}{Q}\right)$ berechnet;

b) die berechnete Phasenverschiebung wird zum Einstellen eines oder mehrerer der örtlichen Oszillatorsignale verwendet, um die Phasendifferenz zwischen einem der örtlichen Oszillatorsignale und dem Träger des empfangenen AM-Signals bei im Wesentlichen null Grad zu aufrechtzuerhalten.

5. Verfahren nach einem der Ansprüche 1 bis 4, ferner umfassend ein Bestimmen eines Frequenzversatzes zwischen einem oder mehreren der Oszillatorsignale und dem Träger des empfangenen AM-Signals.

6. Verfahren nach Anspruch 5, wobei der bestimmte Frequenzversatz zum Abstimmen der Frequenz des einen oder der mehreren örtlichen Oszillatorsignale mit der Frequenz des Trägers des empfangenen AM-Signals verwendet wird.

7. Vorrichtung zum Demodulieren eines amplitudenmodulierten (AM) Signals, umfassend:

einen Analog/Digital-Wandler (12) zum Generieren einer digitalen Darstellung des empfangenen AM-Signals; und
eine digitale Verarbeitungsschaltung (16) zum:

Multiplizieren der digitalen Darstellung mit zwei oder mehr digital generierten, örtlichen Oszillatorsignalen, um ein erstes Signal (I) und ein zweites Signal (Q), das im Wesentlichen 90 Grad zum ersten Signal phasenverschoben ist, zu produzieren; und
Verarbeiten des ersten Signals (I) und des zweiten Signals (Q), um das empfangene AM-Signal zu demodulieren, um ein demoduliertes digitales Signal zu generieren, **dadurch gekennzeichnet, dass** der Verarbeitungsschritt umfasst:

Berechnen der Phasenverschiebung (φ) zwischen den örtlichen Oszillatorsignalen und einer Trägerwelle des empfangenen AM-Signals;
Tiefpassfiltern des ersten Signals (I) zum Generieren eines resultierenden digitalen Signals, b cos φ; und
Multiplizieren des resultierenden Signals, b cos φ, mit dem Arkuskosinus der berechneten Phasenverschiebung (cos⁻¹φ).

**8.** Vorrichtung nach Anspruch 7, wobei die digitale Verarbeitungsschaltung ferner bedienbar ist zum:

Konvertieren des ersten Signals und des zweiten Signals in ein erstes Basisbandsignal und ein zweites Basisbandsignal.

**9.** Vorrichtung nach Anspruch 8, wobei die digitale Verarbeitungsschaltung mindestens ein Tiefpassfilter (30, 32) zum Konvertieren des ersten und zweiten Signals in ein erstes und zweites Basisbandsignal umfasst.

**10.** Vorrichtung nach einem der Ansprüche 8 bis 9, wobei die digitale Verarbeitungsschaltung mindestens ein Hochpassfilter (42) zum Entfernen einer Gleichstromkomponente aus dem digitalen Signal umfasst.

**11.** Vorrichtung nach einem der Ansprüche 8 bis 10, wobei die Phasenverschiebung (φ) durch Berechnen

von $\phi = \tan^{-1}\left(\dfrac{I}{Q}\right)$ berechnet wird;

**12.** Vorrichtung nach einem der Ansprüche 8 bis 11, wobei eines oder mehrere der folgenden zutreffen:

a) die digitale Verarbeitungsschaltung (16) umfasst einen numerisch gesteuerten Oszillator (29) und wobei ein im Wesentlichen Echtzeitwert der Phasenverschiebung dem numerisch gesteuerten Oszillator (29) bereitgestellt wird, um die Frequenz des numerisch kontrollierten Oszillators (29) bei der Trägerfrequenz des empfangenen AM-Signals zu halten.

**Revendications**

**1.** Procédé de démodulation d'un signal modulé en amplitude (AM), le procédé comprenant :

- la réception du signal AM dans un domaine analogique ;
- la génération d'une représentation numérique du signal AM ; et

dans le domaine numérique :

- la multiplication de la représentation numérique par deux, ou plus, signaux d'oscillateur local générés numériquement pour produire un premier signal (I) et un deuxième signal (Q) déphasé de sensiblement 90 degrés par rapport au premier signal ; et
- le traitement du premier signal et du deuxième signal pour démoduler le signal AM reçu afin de générer un signal numérique démodulé, **caractérisé en ce que** l'étape de traitement comprend :

• le calcul du décalage de phase (Φ) entre les signaux d'oscillateur local et une onde porteuse du signal AM reçu ;
• le filtrage passe-bas du premier signal (I) pour générer un signal numérique résultant, b cos Φ ; et
• la multiplication du signal numérique résultant, b cos Φ, par le cosinus inverse du décalage de phase calculé (cos⁻¹ Φ).

**2.** Procédé selon la revendication 1, dans lequel l'étape de traitement comprend :

• la conversion du premier signal et du deuxième signal en un premier signal de bande de base et en un deuxième signal de bande de base.

**3.** Procédé selon la revendication 1 ou 2, comprenant en outre sensiblement le retrait d'une composante CC du signal numérique démodulé.

**4.** Procédé selon l'une quelconque des revendications 1 à 3, dans lequel une ou plusieurs des caractéristiques suivantes s'appliquent :

a) le décalage de phase (Φ) est calculé en calculant Φ = tan⁻¹(I/Q) ;
b) le décalage de phase calculé est utilisé pour ajuster un ou plusieurs des signaux d'oscillateur local afin de maintenir la différence de phase entre l'un des signaux d'oscillateur local et la porteuse du signal AM reçu à sensiblement zéro degré.

**5.** Procédé selon l'une quelconque des revendications 1 à 4, comprenant en outre la détermination d'un décalage de fréquence entre un ou plusieurs des signaux d'oscillateur local et la porteuse du signal AM reçu.

**6.** Procédé selon la revendication 5, dans lequel le décalage de fréquence déterminé est utilisé pour faire correspondre la fréquence des un ou plusieurs des signaux d'oscillateur local avec la fréquence de la porteuse du signal AM reçu.

**7.** Dispositif pour démoduler un signal modulé en amplitude (AM), comprenant :

- un convertisseur analogique-numérique (12) pour générer une représentation numérique d'un signal AM reçu ; et
- des circuits de traitement numérique (16) pour :

• multiplier la représentation numérique par deux, ou plus, signaux d'oscillateur local générés numériquement pour produire un premier signal (I) et un deuxième signal (Q) déphasé de sensiblement 90 degrés par rapport au premier signal ; et
• traiter le premier signal (I) et le deuxième signal (Q) pour démoduler

le signal AM reçu afin de générer un signal numérique démodulé, **caractérisé en ce que** l'étape de traitement comprend :

♦ le calcul du décalage de phase (Φ) entre les signaux d'oscillateur local et une onde porteuse du signal AM reçu ;
♦ le filtrage passe-bas du premier signal (I) pour générer un signal numérique résultant, b cos Φ ; et
♦ la multiplication du signal numérique résultant, b cos Φ, par le cosinus inverse du décalage de phase calculé (cos$^{-1}$ Φ).

8. Dispositif selon la revendication 7, dans lequel les circuits de traitement numérique peuvent en outre servir à :

• convertir le premier signal et le deuxième signal en un premier signal de bande de base et en un deuxième signal de bande de base.

9. Dispositif selon la revendication 8, dans lequel les circuits de traitement numérique comprennent au moins un filtre passe-bas (30, 32) pour convertir les premier et deuxième signaux en les premier et deuxième signaux de bande de base.

10. Dispositif selon l'une quelconque des revendications 8 à 9, dans lequel les circuits de traitement numérique comprennent un filtre passe-haut (42) pour retirer une composante CC du signal numérique démodulé.

11. Dispositif selon l'une quelconque des revendications 8 à 10, dans lequel le décalage de phase (Φ) est calculé en calculant Φ = tan$^{-1}$(I/Q).

12. Dispositif selon l'une quelconque des revendications 8 à 11, dans lequel une ou plusieurs des caractéristiques suivantes s'appliquent :

a) les circuits de traitement numérique (16) comprennent un oscillateur à commande numérique (29) et dans lequel une valeur sensiblement en temps réel du décalage de phase est fournie à l'oscillateur à commande numérique (29) afin de maintenir la fréquence de l'oscillateur à commande numérique (29) à la fréquence porteuse du signal AM reçu.

FIG. 1

FIG. 2

FIG. 3

FIG. 4

EP 2 797 225 B1

**REFERENCES CITED IN THE DESCRIPTION**

**Non-patent literature cited in the description**

- **VEERENDRA BHARGAV ALLURI, J. et al.** A New Multichannel, Coherent AM, TDM, SDR Receiver Architecture, and FPGA Technology Implementation. *IEEE Sig. Proc.,* October 2010, vol. 58 (10), 5369-5384

- **FRIGON J. et al.** Field trial results for high-speed wireless indoor data communications. *IEEE Journal on selected areas in communications,* 01 March 2000, vol. 18 (3), 297-309